(11) **EP 1 073 119 B1**

(12) **EUROPEAN PATENT SPECIFICATION**

(45) Date of publication and mention
of the grant of the patent:
**26.05.2004 Bulletin 2004/22**

(51) Int Cl.⁷: $H01L\ 27/00$, $H01L\ 27/02$

(21) Application number: **99830491.9**

(22) Date of filing: **30.07.1999**

(54) **ESD protection device for semiconductor integrated circuit structure**

ESD-Schutzbauteil für eine integrierte Schaltungsstruktur

Dispositif de protection contre les décharges électrostatiques pour un circuit intégré

(84) Designated Contracting States:
**DE FR GB IT**

(43) Date of publication of application:
**31.01.2001 Bulletin 2001/05**

(73) Proprietor: **STMicroelectronics S.r.l.**
**20041 Agrate Brianza (Milano) (IT)**

(72) Inventor: **Colombo, Paolo**
**21049 Tradate, Varese (IT)**

(74) Representative: **Botti, Mario**
**Botti & Ferrari S.r.l.,**
**Via Locatelli, 5**
**20124 Milano (IT)**

(56) References cited:
**EP-A- 0 932 202**      **EP-A- 0 932 203**
**US-A- 4 760 433**      **US-A- 5 602 409**

## Description

Field of the Invention

This invention relates to an ESD protection device for circuit structures integrated in a semiconductor substrate and having at least one supply terminal arranged to receive a positive or negative voltage potential.

More particularly, the invention relates to a device as above which comprises an ESD protection transistor formed in the substrate surface, within an isolated region from the substrate.

As is well known, many semiconductor integrated electronic circuits, such as logic circuits or memory circuits, are provided with protective structures against electrostatic discharges.

Such structures are commonly known as ESD protectors, and are used to only become active in particular situations, e.g. on the occurrence of "snap-back" of the parasitic bipolar. This bipolar is an npn lateral transistor with field oxide (field oxide bipolar) which is liable to experience a breakdown from the collector terminal to the substrate as the base/emitter junction is forward biased.

The parasitic npn lateral bipolar is usually employed as a protection member in processes using 0.5 micrometer CMOS technology, since it is a parasitic component inherent to the process and, therefore, not adding to the manufacturing cost. This transistor is in fact biased with the base/substrate to ground, and does not interfere with the operability of the devices.

Non-volatile memory circuits are a typical example of electronic circuits that require ESD protection and are formed with submicron CMOS technology.

Negative voltages are also utilized in such circuits at the memory cell programming and/or erasing steps. Such negative voltages are generated internally of the integrated circuit by a charge pump arrangement.

Although, in order to test the integrated circuit, the circuit must also be provided with a supply terminal adapted to receive a negative or positive voltage potential.

It is, however, important to observe that, for a memory circuit to be applied negative voltages, the memory circuit should be formed in a region which is completely isolated from the native semiconductor substrate. This isolation is achieved by a technique known as "triple wells" which consists basically of carrying out a high-energy implantation effective to produce, in the substrate, a buried layer peripherally in contact with an annular well which extends downwards from the substrate surface. This structure enables a region to be trapped between the well and the buried layer which is completely isolated from the native substrate and wherein the cells of the memory circuit can be formed.

Another known protection circuit is described in the US Patent No. 5,602,409 to Olney et al.. In particular, this document describes an electrical overstress protection circuit comprising a pair of contra-directed diode-connected bipolar transistors, a pair of parasitic transistors being formed in series to provide a current path between the above transistors.

While the known isolation structures are in many ways advantageous and essentially achieves its objective, some problems may be encountered in providing it with an effective ESD protection where negative voltages are used.

In fact, the protection structures currently in use provide no adequate protection in the event of large variations appearing in a negative voltage applied to the external supply pin.

The basic technical problem of the present invention is that of providing an effective ESD protection device for circuit structures integrated on a semiconductor substrate which are also subjecting variable negative supply voltages within a predetermined value range.

Summary of the Invention

The principle of the present invention is that of having a pair of protection transistors connected in series and formed, the one within an isolated region from the substrate and the other without said isolated region.

Based on this principle, the technical problem is solved by a device as previously indicated and defined by the characterizing part of Claim 1.

The features and advantages of a device according to the invention can be more clearly understood by reading the following description of an embodiment thereof, given by way of non-limitative example with reference to the following drawings.

Brief Description of the Drawing

Figure 1A is a vertical cross-section view, drawn to an enlarged scale, showing schematically a semiconductor portion wherein an ESD protection structure according to the invention has been formed.

Figure 1B is a vertical cross-section view, drawn to an enlarged scale, showing schematically a second embodiment of the protection structure of Figure 1A.

Figure 2A shows an equivalent electric diagram of the protection structure of Figure 1A.

Figure 2B shows an equivalent electric diagram of the protection structure of Figure 1B.

Figures 3A and 3B are schematic views of the protection structures of Figure 2A and Figure 2B, respectively.

Detailed Description

Referring to the drawing views, specifically to the example of Figure 1A, an ESD protection circuit structure according to the invention is generally shown in schematic form at 1.

The structure 1 is formed on a native semiconductor substrate 2. The substrate 2 has been doped with a first dopant type, e.g. a P-type dopant, at a selected dosage, and has a high resistivity of a few tens of Ohms per centimeter. The substrate 2 is normally biased to a predetermined value of potential, e.g. a ground potential GND.

The structure 1 is intended to protect an integrated circuit which may be, particularly but not exclusively, a non-volatile memory circuit formed in the substrate 2.

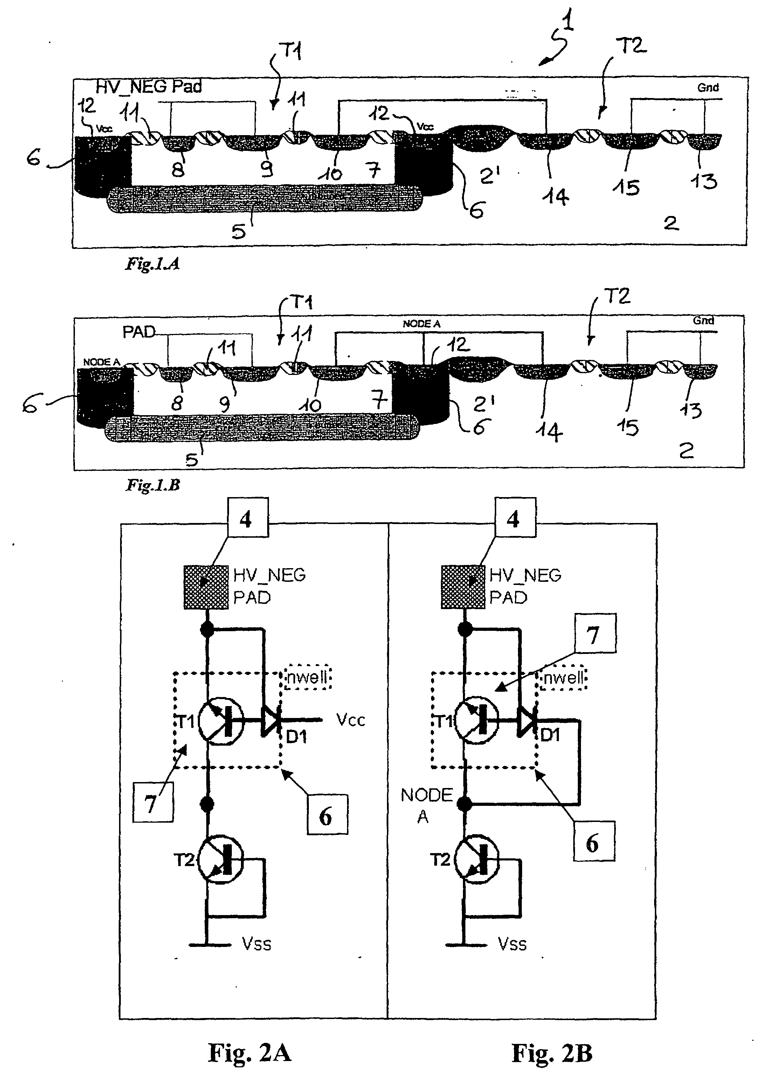

The integrated circuit is basically of conventional design, and for brevity, no detailed description of such a circuit will be given herein. The single point of significance for the understanding of this invention is the presence of a supply pin associated with the integrated memory circuit to enable the circuit to be applied positive or negative supply voltages from outside. This pin is represented schematically by a termination 4 PAD in Figures 2a and 2B whereto a negative voltage HV_NEG can be applied.

The ESD protection structure 1 is associated with the integrated circuit to be protected, and is connected between the supply pin 4 and a reference of potential, such as a ground potential GND or a Vss voltage.

An epitaxial layer 2' is grown to a predetermined thickness on the substrate 2. In addition, an N-doped buried region 5 is formed within the layer 2' over the substrate 2.

The region 5 is provided by a high-energy implantation, preferably of phosphorus. The implantation energy will lie in the MegaeV range.

An annular N-well 6 extends to contact the periphery of the buried region 5 from the substrate surface, it enclosing and isolating a region 7 wherein a first protection transistor T1 is formed. The transistor T1 is a field oxide, npn lateral bipolar for ESD protection. This transistor is formed in the surface of the epitaxial layer 2'.

Alternatively, the transistor T1 could be an npn parasitic bipolar of an NMOS transistor having its gate terminal taken to ground GND.

Thus, the transistor T1 is formed in an isolated substrate region 7, and comprises a base region 8, an emitter region 9, and a collector region 10. The base region 8 is a surface pocket doped P+. The regions 9 and 10 are surface pockets doped N+.

The regions 8, 9 and 10 are formed in the surface of the epitaxial layer 2' and are isolated from one another by field oxide areas 11.

Advantageously, the base 8 and emitter 9 of the transistor T1 are connected to each other and the supply pin termination 4.

The N-well region 6 comprises, in the center and on the surface, a contact region 12 having a higher N+ dopant concentration. This region 12 is biased to a positive supply voltage Vcc.

A second protection transistor T2 is provided according to the invention which is also of the lateral bipolar type with NPN conductivity.

The transistor T2 is formed laterally of the transistor T1 in the substrate 2, but outside the isolating region 7.

The transistor T2 comprises a base region 13 of the P+ type, a collector region 14 of the N+ type, and an emitter region 15 of the N+ type.

The regions 13, 14 and 15 are formed in the surface of the substrate 2 and are isolated from one another by oxide regions 21.

The base 13 and emitter 15 regions are connected to a common voltage reference, such as the voltage Vss or the ground GND.

On the other hand the collector region 14 of the transistor T2 is connected to the collector region 10 of the transistor T1 so that the two transistors are connected essentially in series with each other.

Advantageously in a first embodiment, shown in Figures 1A and 2A, the structure 1 includes a parasitic diode D1 between the substrate P and the N+ region. The diode D1 is formed essentially from the junction between the base region 8 of the transistor T1 and N-well 6 and N-buried 5 annular regions.

The presence of the diode D1, in combination with the contact region 12 being biased to the value of the voltage Vcc, provides the structure 1 of this invention with a protection feature which typifies those structures which have N+ junction leakage currents to the substrate.

The voltage HV_NEG, which can be applied to the termination 4 of the supply pin, varies within the following range:

$$-(Vt + V_{BKD}) < V_{PAD} < Vt + Vcc$$

where, Vt is the threshold voltage of the forward biased diode D1 (usually 0.6V), and $V_{BKD}$ is the breakdown voltage of the N+ junction.

The value of $V_{BKD}$ is higher than the maximum voltage (whether positive or negative) required for writing in the memory cells of the integrated memory circuit.

The voltage Vcc represents the supply to the integrated circuit, and may vary within the range of 1.8V to 5V.

In an alternative embodiment illustrated by Figures 1B and 2B, the region 12 is connected to a circuit node A as shown in Figure 2B, for example.

In this case, the cathode of the diode D1 is connected to the node A, thereby providing ESD protection by the direct discharge path between the termination 4 and the voltage reference Vcc.

In this second embodiment, the termination 4 can be applied a wider voltage range. In essence, HV_NEG may vary between:

$$-(Vt + V_{BKD}) < V_{PAD} < Vt + V_{BKD}.$$

In this second embodiment, no direct protection path to Vcc exists. However, the discharge path to the voltage reference Vcc is already covered by a series of the protection to ground GND and a protection diode Vcc/Vss, which is always present in integrated circuits of this type and formed from the P+/Psubstrate/N+ junctions.

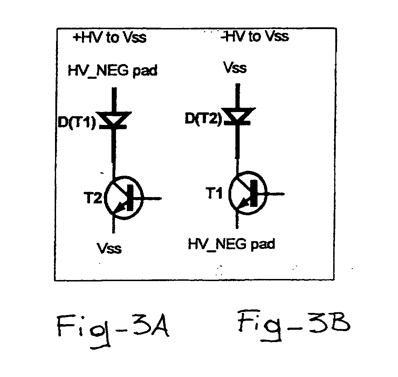

Shown in Figures 3A and 3B, respectively, are the electric diagrams for the protection paths that would become active upon the occurrence of a positive and/or negative voltage type of electrostatic discharge at the termination 4.

Specifically, Figure 3A shows the path from HV_NEG to Vss, because of the presence of a diode D (T1) which represents the base/collector parasitic diode of the lateral bipolar T1.

Figure 3B shows the discharge path from Vss to HV_NEG through a base/collector parasitic diode D (T2) of the lateral bipolar T2.

In summary, the invention achieves a more effective type of ESD protection by providing a more effective discharge path between the termination 4 of the supply pin and at least a second supply reference.

This is obtained almost apart from the parameters which are responsible for the latching up of ESD protected electronic devices.

**Claims**

1. An ESD protection device (1) for circuit structures integrated in a semiconductor substrate (2) of a first dopant type (P) and having at least one supply terminal (4) arranged to receive a positive or negative voltage potential, the device (1) comprising:

   - a first lateral bipolar transistor (T1) formed in the surface of the substrate (2), inside an isolated region (7) from the substrate (2) and having a base contact region (8) of said first dopant type (P) connected to an emitter region (9) of a second dopant type (N) and a collector region (10) of said second dopant type (N), said isolated region (7) from the substrate (2) being bounded by a buried region (5) of said second dopant type (N) and an annular well (6) of said second dopant type (N) peripherally contacting said buried region (5) from the surface of said substrate (2),

   - a second lateral bipolar transistor (T2) formed in the substrate (2) outside said isolated region (7) and having a base region (13) of said first dopant type (P) and an emitter region (15) of said second dopant type (N), as well as a collector region (14) of said second dopant type (N)

   wherein

   - said collector region (14) of said second lateral bipolar transistor (T2) is connected to a collector region (10) of said first lateral bipolar transistor (T1) such that the transistors are connected in series between said supply terminal and a terminal of reference of potential;

   - said base contact region (8) and said emitter region (9) of said first lateral bipolar transistor (T1) are connected to each other and to said supply terminal (4); and

   - a junction between said base contact region (8) of said first lateral bipolar transistor (T1) and said buried region (5) and said annular well (6) forming a parasitic diode (D1).

2. A device according to Claim 1, **characterized in that** said second transistor (T2) is of the field oxide type.

3. A device according to Claim 1, **characterized in that** said annular well (6) includes, centered on its surface, a contact region (12) of said second dopant type (N).

4. A device according to Claim 1, **characterized in that** said annular well (6) includes, centered on its surface, a contact region (12) of said second dopant type (N) which is connected to an interconnection node (A) between said first (T1) and second (T2) lateral bipolar transistors.

5. A device according to Claim 1, **characterized in that** said first transistor (T1) is a lateral bipolar having a distributed base isolated region (7).

6. A device according to Claim 1, **characterized in that** said base region (13) and emitter region (15) of said second lateral bipolar transistor (T2) are connected to a common voltage reference.

7. A device according to Claim 1, **characterized in that** said second transistor (T2) is NPN bipolar.

## Patentansprüche

1. Eine ESD-Schutzvorrichtung (1) für in ein Halbleitersubstrat (2) eines ersten Dotiertyps (P) integrierte Schaltungsstrukturen, die mindestens einen zum Empfangen eines positiven oder negativen Spannungspotentials ausgelegten Speiseanschluss (4) aufweist, wobei die Vorrichtung (1) aufweist:

   - einen ersten bipolaren Lateral-Transistor (T1), der in der Oberfläche des Substrats (2) innerhalb einer isolierten Region (7) des Substrats (2) ausgebildet ist und eine Basis-Kontaktzone (8) vom ersten Dotiertyp (P), die mit einer Emitterzone (9) eines zweiten Dotiertyps (N) verbunden ist, und eine Kollektorzone (10) vom zweiten Dotiertyp (N) aufweist, wobei die isolierte Region (7) des Substrats (2) durch einen vergrabenen Bereich (5) vom zweiten Dotiertyp (N) und eine ringförmige Wanne (6) vom zweiten Dotiertyp (N), die den vergrabenen Bereich (5) von der Oberfläche des Substrats (2) aus von außen berührt, begrenzt wird,
   - einen zweiten bipolaren Lateral-Transistor (T2), der im Substrat (2) außerhalb der isolierten Region (7) ausgebildet ist und eine Basiszone (13) vom ersten Dotiertyp (P) und eine Emitterzone (15) vom zweiten Dotiertyp (N) sowie eine Kollektorzone (14) vom zweiten Dotiertyp (N) aufweist,

   wobei

   - die Kollektorzone (14) des zweiten bipolaren Lateral-Transistors (T2) mit einer Kollektorzone (10) des ersten bipolaren Lateral-Transistors (T1) so verbunden ist, dass die Transistoren in Reihe zwischen den Speiseanschluss und einen Referenzpotential-Anschluss geschaltet sind;
   - die Basis-Kontaktzone (8) und die Emitterzone (9) des ersten bipolaren Lateral-Transistors (T1) miteinander und mit dem Speiseanschluss (4) verbunden sind; und
   - ein Übergang zwischen der Basis-Kontaktzone (8) des ersten bipolaren Lateral-Transistors (T1) und dem vergrabenen Bereich (5) und der ringförmigen Wanne (6) eine parasitäre Diode (D1) bildet.

2. Eine Vorrichtung entsprechend Anspruch 1, **dadurch gekennzeichnet, dass** der zweite Transistor (T2) vom Feldoxid-Typ ist.

3. Eine Vorrichtung entsprechend Anspruch 1, **dadurch gekennzeichnet, dass** die ringförmige Wanne (6) eine zentral auf ihrer Oberfläche angeordnete Kontaktzone (12) vom zweiten Dotiertyp (N) umfasst.

4. Eine Vorrichtung entsprechend Anspruch 1, **dadurch gekennzeichnet, dass** die ringförmige Wanne (6) eine zentral auf ihrer Oberfläche angeordnete Kontaktzone (12) vom zweiten Dotiertyp (N) umfasst, die mit einem Verbindungsknoten (A) zwischen dem ersten (T1) und zweiten (T2) bipolaren Lateral-Transistor verbunden ist.

5. Eine Vorrichtung entsprechend Anspruch 1, **dadurch gekennzeichnet, dass** der erste Transistor (T1) ein bipolarer Lateral-Transistor ist, der eine verteilte, von der Basis isolierte Region (7) aufweist.

6. Eine Vorrichtung entsprechend Anspruch 1, **dadurch gekennzeichnet, dass** die Basiszone (13) und Emitterzone (15) des zweiten bipolaren Lateral-Transistors (T2) mit einer gemeinsamen Spannungsreferenz verbunden sind.

7. Eine Vorrichtung entsprechend Anspruch 1, **dadurch gekennzeichnet, dass** der zweite Transistor (T2) bipolar NPN ist.

## Revendications

1. Dispositif de protection ESD (1) pour des structures de circuit intégrées dans un substrat de semi-conducteur (2) d'un premier type de dopant (P) et ayant au moins une borne d'alimentation (4) disposée de façon à recevoir une tension positive ou négative, le dispositif (1) comprenant :

   - un premier transistor bipolaire latéral (T1) formé à la surface du substrat (2), au sein d'une région isolée (7) du substrat (2) et ayant une région de contact de base (8) dudit premier type de dopant (P) reliée à une région d'émetteur (9) d'un deuxième type de dopant (N) et une région de collecteur (10) dudit deuxième type de dopant (N), ladite région isolée (7) du substrat (2) étant liée par une région ensevelie (5) dudit deuxième type de dopant (N) et un puits annulaire (6) dudit deuxième type de dopant (N) étant en contact périphérique avec ladite région ensevelie (5) de la surface dudit substrat (2),

   - un deuxième transistor bipolaire latéral (T2) formé dans le substrat (2) à l'extérieur de ladite région isolée (7) et ayant une région de base (13) dudit premier type de dopant (P) et une région d'émetteur (15) dudit deuxième type de dopant (N), ainsi qu'une région de collecteur (14) dudit deuxième type de dopant (N)

   dans lequel

-   ladite région de collecteur (14) dudit deuxième transistor bipolaire latéral (T2) est reliée à une région de collecteur (10) dudit premier transistor bipolaire latéral (T1), de sorte que les transistors sont raccordés en série entre ladite borne d'alimentation et une borne de référence de tension

-   ladite région de contact de base (8) et ladite région d'émetteur (9) dudit premier transistor bipolaire latéral (T1) sont reliées entre elles et ladite borne d'alimentation (4) ; et

-   une jonction entre ladite région de contact de base (8) dudit premier transistor bipolaire latéral (T1) et ladite région ensevelie (5) et ledit puits annulaire (6) formant une diode parasite (D1).

2.  Dispositif selon la revendication 1, **caractérisé en ce que** ledit deuxième transistor (T2) est de type oxyde de champ.

3.  Dispositif selon la revendication 1, **caractérisé en ce que** ledit puits annulaire (6) comprend, au centre de sa surface, une région de contact (12) dudit deuxième type de dopant (N).

4.  Dispositif selon la revendication 1, **caractérisé en ce que** ledit puits annulaire (6) comprend, au centre de sa surface, une région de contact (12) dudit deuxième type de dopant (N) qui est reliée à un noeud d'interconnexion (A) entre lesdits premier (T1) et deuxième (T2) transistors bipolaires latéraux.

5.  Dispositif selon la revendication 1, **caractérisé en ce que** ledit premier transistor (T1) est un transistor bipolaire latéral ayant une région isolée de base à constantes réparties (7).

6.  Dispositif selon la revendication 1, **caractérisé en ce que** ladite région de base (13) et la région d'émetteur (15) dudit deuxième transistor bipolaire latéral (T2) sont reliées à une référence de tension commune.

7.  Dispositif selon la revendication 1, **caractérisé en ce que** ledit deuxième transistor (T2) est un transistor bipolaire NPN.

Fig.1.A

Fig.1.B

Fig. 2A

Fig. 2B

Fig-3A       Fig-3B